# EUROPÄISCHE PATENTANMELDUNG

(11) **EP 1 271 635 A1**
(43) Veröffentlichungstag der Anmeldung: **02.01.2003**
(21) Anmeldenummer: 01110132.6
(22) Anmeldetag: 03.05.2001
(51) Int. Cl.: H01L 21/314, H01L 21/265, H01L 21/316

(54) **Verfahren zur thermischen Oxidation eines implantierten Halbleitersubstrates**

(71) Anmelder: Infineon Technologies AG, 81669 München (DE)
(72) Erfinder: Kerber, Martin, 81827 München (DE); Wurzer, Helmut, 01109 Dresden (DE); Pompl, Thomas, 84032 Altdorf (DE)
(74) Vertreter: Reinhard - Skuhra - Weise & Partner

(57) **Zusammenfassung**

Die vorliegende Erfindung schafft ein Verfahren zum Bilden eines Dielektrikums 1; 7, 8 auf einem Halbleitersubstrat 2 mit folgenden Schritten: Implantieren von Ionen in eine Oberflächenschicht des Halbleitersubstrats 2, wobei die Ionen eine erste dielektrische Schicht 7 bilden; und Ausführen eines thermischen Oxidationsprozesses zum Bilden einer zweiten dielektrischen Schicht 8 auf der ersten dielektrischen Schicht 7. Somit kann z.B. durch die Implantation von Stickstoffionen in eine Oberflächenschicht eines Siliziumsubstrates die Fehlstellendichte des gebildeten Dielektrikums um etwa den Faktor 10 reduziert werden.

## Beschreibung

Die vorliegende Erfindung betrifft ein Verfahren zum Bilden eines Dielektrikums auf einem Halbleitersubstrat vorzugsweise in integrierten Schaltungen.

Bei der Miniaturisierung im Bereich der Elektronik mit dem Ziel, kleinste elektronische Geräte möglichst hoher Zuverlässigkeit und Lebensdauer herzustellen, die dennoch eine Vielzahl elektronischer Bau- und Schaltelemente enthalten, spielen integrierte Schaltungen seit längerem eine dominierende Rolle. Hierbei ist z.B. bei allen Feldeffekt-Bauelementen ein Dielektrikum der wesentliche Bestandteil des Bauelementes, welcher die Lebensdauer eines Chip vorbestimmt. Die Zuverlässigkeit eines Dielektrikums wiederum wird im wesentlichen durch seine Defektdichte bzw. seine Fehlstellendichte charakterisiert.

Üblicherweise wird zur Bildung eines Dielektrikums auf einem Substrat folgendermaßen vorgegangen.

Ausgehend von einem üblicherweise verwendeten Halbleitersubstrat, d.h. es befinden sich von vornherein schon verschiedene Arten von Fehlstellen mit bestimmter Dichte im Kristall, wird dessen Oberfläche mittels einer speziellen Reinigungssequenz gesäubert. Diese Reinigungssequenz umfasst unter anderem ein Aufbringen einer speziell ausgewählten Reinigungschemie, mit deren Hilfe Fremdpartikel auf der Oberfläche des Substrates beseitigt werden sollen. Anschließend folgt ein Bilden einer Dielektrikumsschicht auf der SubstratOberfläche, z.B. eine Oxidationsschicht mittels einem gängigen Oxidationsverfahren.

Weiterhin können als Halbleitersubstrate sogenannte "perfekte Substrate" verwendet werden, bei denen die Fehlstellen mittels aufwendiger Verfahren schon bei der Herstellung des Substrates vollständig beseitigt werden. Diese "perfekten Substrate" jedoch sind bedingt durch ihren aufwendigen Herstellungsprozess viel zu teuer und stellen somit eine Alternative mit wirtschaftlichem Nachteil dar. Da die elektronischen Bauund Schaltelemente in einer großen Menge hergestellt werden, spielt gerade der Kostenfaktor ebenso eine große Rolle wie ein einfaches und automatisiertes Herstellungsverfahren.

Somit ist es ökonomischer gängige Halbleitersubstrate mit bestimmter Fehlstellendichte als Ausgangsmaterial zu verwenden und mittels üblicher Reinigungssequenzen die Defektdichte in diesen zu verringern.

Die Anforderungen an z.B. solche Feldeffekt-Bauelemente werden immer höher geschraubt. Es wird häufig von der Industrie eine Ausfallwahrscheinlichkeit von einigen 100 ppm bei einer mittleren Lebensdauer von 15 Jahren als Anforderung an einen Chip gestellt, d.h., dass nur eine äußerst geringe Anzahl an Transistoren insgesamt während der 15 Jahre ausfallen dürfen. Die Lebensdauer eines Transistors hängt wiederum im wesentlichen von der Reinheit des Dielektrikums ab, da eine hohe Fehlstellendichte des Dielektrikums eine höhere Wahrscheinlichkeit für einen elektrischen Durchschlag nach einer bestimmten Zeitdauer zur Folge hat. Durch diese Verringerung der Fehlstellen im Dielektrikum kann die Wahrscheinlichkeit für einen elektrischen Durchschlag stark verringert werden und somit die Lebensdauer eines einzelnen Bau- und Schaltelementes erhöht werden.

Da es nun Ziel der Industrie ist, immer komplexere Chips herzustellen mit immer größerer Anzahl an Transistoren, muss für eine Einhaltung der Lebensdauer von 15 Jahren die Wahrscheinlichkeit für einen Defekt eines Transistors verringert werden, um so die absolute Ausfallrate von Transistoren auf einem Chip beizubehalten.

Somit ist es Aufgabe der vorliegenden Erfindung, ein einfaches und kostengünstiges Verfahren zur Verfügung zu stellen, mit dem ein Dielektrikum auf einem Halbleitersubstrat mit geringerer Fehlstellendichte als nach dem Stand der Technik aufgebracht werden kann.

Diese Aufgabe wird gelöst durch das erfindungsgemäße Verfahren mit den Merkmalen des Anspruchs 1.

Die der vorliegenden Erfindung zugrundeliegende Idee besteht darin, dass zum Bilden eines Dielektrikums auf einem Halbleitersubstrat zunächst Ionen in eine Oberflächenschicht des Halbleitersubstrates implantiert werden, wobei die Ionen eine erste dielektrische Schicht bilden; und anschließend ein Oxidationsprozess zum Bilden einer zweiten dielektrischen Schicht auf der ersten dielektrischen Schicht ausgeführt wird.

Durch diese Verfahrensschritte kann eine Reduzierung der Fehlstellendichte im gesamten Dielektrikum, welches sich aus der ersten dielektrischen Schicht und der zweiten dielektrischen Schicht zusammensetzt, erreicht werden.

Mit anderen Worten wird im Bereich der Defekte ein relativ dickeres Oxid erzeugt, indem dort die retardierende Wirkung von N-Atomen reduziert ist.

In den Unteransprüchen finden sich vorteilhafte Weiterbildungen und Verbesserungen des in Anspruch 1 angegebenen Verfahrens.

Gemäß einer bevorzugten Ausgestaltung der Erfindung ist das Halbleitersubstrat vorzugsweise als Siliziumsubstrat ausgebildet. Silizium hat sich mittlerweile als gängigstes Wafermaterial behauptet, da es gegenüber anderen Halbleitermaterialien besonders geeignete elektrische Eigenschaften aufweist.

Gemäß einer weiteren Ausgestaltung sind die implantierten Ionen Stickstoffionen. Durch die Implantation dieser Stickstoffionen wurde eine Verringerung der Fehlstellendichte des Dielektrikums bei Verwendung eines Siliziumsubstrates etwa um den Faktor 10 festgestellt, was eine Reduktion der Fehlerwahrscheinlichkeit innerhalb der Lebensdauer bedeutet.

Gemäß einer weiteren bevorzugten Weiterbildung wird ein Reinigungsprozess zur Reinigung der Halbleitersubstratoberfläche vor dem Bilden des Dielektrikums ausgeführt. Durch dieses Reinigungsverfahren soll bereits ein Großteil von Störstellen wie z.B. Fremdpartikel auf der Substratoberfläche, die sich im Laufe der Lagerung und des Transportes des Substrates an diesem anheften, beseitigt werden.

Gemäß einer weiteren bevorzugten Ausgestaltung der Erfindung werden die durch die Ionenimplantation entstandenen Fehlstellen mittels eines Temperungsverfahrens vor dem thermischen Oxidationsprozess beseitigt. Jedes Implantationsverfahren hat ein Bilden von bestimmten Fehlstellen zur Folge, welche eine Erhöhung der gesamten Fehlstellendichte bewirken. Diese durch die Ionenimplantation entstandenen Fehlstellen sind jedoch leicht durch ein bestimmtes Temperungsverfahren wieder aus dem Kristall zu beseitigen.

Nach einer weiteren bevorzugten Ausgestaltung wird eine Streuschicht zum Herstellen einer vorbestimmten Eindringtiefe der Ionen vor der Implantation erzeugt und nach der Implantation noch vor dem thermischen Oxidationsprozess wieder entfernt. Diese Streuschicht kann eine natürliche Oxidschicht oder eine aufgebrachte Oxidschicht sein. Beim Implantationsprozess entstehen auch in dieser Streuschicht etliche Störstellen, hauptsächlich durch aufgebrachte Fremdpartikel. Deshalb wird diese vorteilhaft noch vor dem thermischen Oxidationsprozess wieder von der Substratoberfläche entfernt.

Ausführungsbeispiele der Erfindung sind in den Zeichnungen dargestellt und in der nachfolgenden Beschreibung näher erläutert. Es zeigen:
- Fig. 1: eine perspektivische Ansicht eines Siliziumsubstrats mit einer bestimmten Fehlstellendichte gemäß einem Ausführungsbeispiel der vorliegenden Erfindung;
- Fig. 2: eine perspektivische Ansicht des Siliziumsubstrats mit aufgebrachter Streuschicht während dem Beschuss mit Stickstoffionen gemäß der Ausführungsform aus Fig. 1;
- Fig. 3: eine perspektivische Ansicht des Siliziumsubstrats nach der Implantation von Stickstoffionen mit einer ersten dielektrischen Schicht aus SiN gemäß dem Ausführungsbeispiel aus Fig. 1 und 2; und
- Fig. 4: eine perspektivische Ansicht eines Siliziumsubstrats nach einem thermischen Oxidationsprozess mit einer ersten dielektrischen Schicht aus SiN und einer zweiten dielektrischen Schicht aus SiO₂ gemäß dem Ausführungsbeispiel der vorliegenden Erfindung aus Fig. 1, 2 und 3.

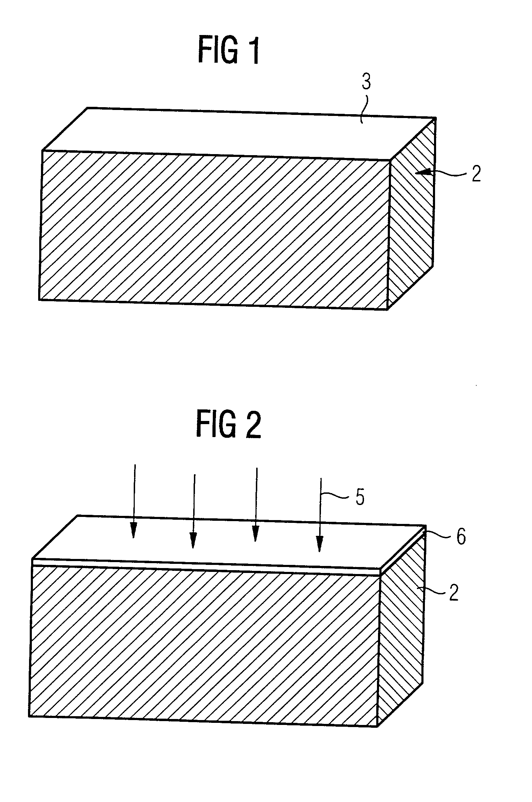

Fig. 1 zeigt ein üblicherweise verwendetes Siliziumsubstrat 2 mit einer bestimmten Fehlstellendichte. Diese Fehlstellen können sowohl als Verunreinigungen auf der Oberfläche des Halbleitersubstrats als auch als Defekte aufgrund von Gitterverschiebungen, Fremdatomen, etc. im Kristallinneren ausgebildet sein. Von diesem Siliziumsubstrat 2 ausgehend soll nun wie oben beschrieben ein Dielektrikum 1 oben auf dem Siliziumsubstrat 2 derart gebildet werden, dass eine elektrisch isolierende Schicht 1 mit bestimmten elektrischen Eigenschaften zwischen dem Halbleitersubstrat 2 und z.B. einer Gate-Elektrode entsteht. Eine Verbesserung dieser elektrisch isolierenden dielektrischen Schicht 1 erreicht man durch eine Reduktion der in dieser herrschenden Fehlstellendichte. Um nun ein Dielektrikum mit einer möglichst geringen Fehlstellendichte herzustellen, wird ausgehend von dem in Fig. 1 dargestellten Halbleitersubstrat gemäß einer bevorzugten Ausführungsform der vorliegenden Erfindung wie folgt vorgegangen.

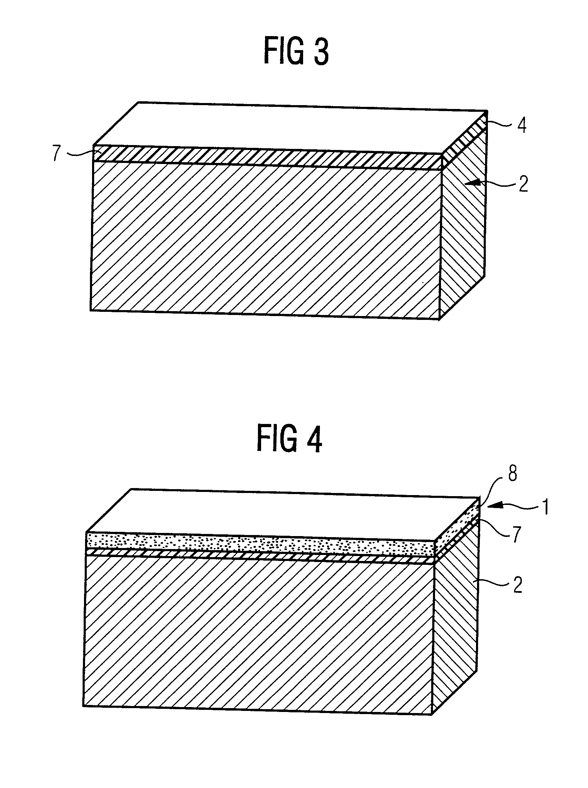

Es wird zunächst die Oberfläche des Substrates 2 gründlich von Verunreinigungen gesäubert. Hierzu wird z.B. eine speziell ausgewählte Reinigungschemie auf der Siliziumsubstrat-Oberfläche 3 aufgebracht, welche die Fremdatome bindet, und anschließend wieder von der Siliziumsubstrat-Oberfläche 3 mitsamt der gebundenen Fremdatome entfernt. Zum Herstellen einer für eine Ionenimplantation notwendigen vorbestimmten Eindringtiefe wird anschließend eine Streuoxidschicht 6 mit einer Schichtdicke von ca. 4,0 nm, wie in Fig. 2 dargestellt, auf der Siliziumsubstrat-Oberfläche 3 aufgebracht. Zur Erzeugung von Stickstoffionen für einen Stickstoffionenstrahl 5 wird Ammoniak durch eine Ionisationskammer geschickt, wobei die Gasmoleküle durch eine Feldemission ionisiert werden. Danach werden die Stickstoffionen über einen Massenseparator extrahiert und auf etwa 25 bis 35 keV beschleunigt. Danach wird zur Implantation der Stickstoffionen der Stickstoffionenstrahl 5 über die Siliziumsubstrat-Oberfläche 3 mit aufgebrachter Streuschicht 6 so lange geführt, bis eine gewünschte Dosis an Stickstoffionen in der Substrat-Oberflächenschicht 4 erreicht ist, die durch die Integration des elektrischen Stroms kontrolliert wird.

Mittels der Implantation der Ionen auf die Streuschicht 6 auf der Siliziumsubstrat-Oberfläche 3 ist eine Eindringtiefe der Stickstoffionen im Siliziumsubstrat 2 von ungefähr 30 bis 50 nm herstellbar.

Die höchste Konzentration an N-Atomen befindet sich an der Oberfläche, so dass sich, wie in Fig. 3 gezeigt, in der Oberflächenschicht 4 im Siliziumsubstrat 2 eine erste dielektrische Schicht 7, bestehend aus SiN, bildet. Wie in Fig. 2 ersichtlich, wird die Streuschicht 6 unmittelbar nach Beendigung des Ionenimplantationsprozesses von der Siliziumsubstrat-Oberfläche 3 mittels einem nasschemischen Ätzverfahren entfernt, da diese Streuschicht im Verlauf des Implantationsverfahrens mit Fremdatomen verunreinigt wird und so eine zu hohe Fehlstellendichte aufweist.

Ferner werden durch die Implantation in der Substrat-Oberflächenschicht 4 Implantationsdefekte in dieser Schicht 4 erzeugt. Diese unerwünschten Fehlstellen sind jedoch durch ein Annealing-Verfahren, einem Verfahrensschritt, bei dem der Siliziumwafer bei einer hohen Temperatur gelagert wird (1000 °C, 30 Minuten), aus dem Siliziumkristall 2 entfernbar.

Durch einen thermischen Oxidationsprozess wird auf der Siliziumsubstratoberfläche eine Oxidschicht erzeugt, wobei die Anwesenheit von N-Atomen an der Oberfläche die Oxidation behindert. Es entsteht somit ein etwas dünneres Oxid als bei den gleichen Prozessbedingungen ohne N-Atome entstehen würde. Befindet sich nun ein Partikel an der Oberfläche oder schneidet die Oberfläche gerade ein Leerstellenagglomerat, so wird dort die Dichte von N-Atomen weniger behindert und es entsteht ein dickeres Oxid verglichen mit Oxid der ungestörten, durch N-Atome angereicherten Substratoberfläche. Durch diese Retardierung der Oxidation im ungestörten Bereich und Aufhebung der retardierenden Wirkung im Bereich von Fehlstellen wird im Bereich der Fehlstellen die Durchbruchspannung angehoben, so dass sie nicht mehr als Defekte des Dielektrikums wirken.

Damit ist die Voraussetzung für ein Herstellen von großflächigeren Chips ohne eine Erhöhung der Ausfallswahrscheinlichkeit gewährleistet.

Die implantierten Stickstoffionen sorgen offensichtlich dafür, dass die im Siliziumsubstrat 2 herrschenden Fehlstellen so vorbereitet werden, dass sie während der Oxidation schneller oxidieren und somit eine dickere Oxidationsschicht bilden. Somit stellt diese Defektstelle keine Gefahr für einen elektrischen Durchschlag mehr dar.

Obwohl die vorliegende Erfindung anhand eines bevorzugten Ausführungsbeispiels vorstehend beschrieben wurde, ist sie darauf nicht beschränkt, sondern auf vielfältige Weise modifizierbar.

### Bezugszeichenliste

- 1: Dielektrikum
- 2: Halbleitersubstrat
- 3: Halbleitersubstrat-Oberfläche
- 4: Halbleitersubstrat-Oberflächenschicht
- 5: Stickstoffionenstrahl
- 6: Streuschicht
- 7: erste dielektrische Schicht (SiN)
- 8: zweite dielektrische Schicht (SiO₂)

## Patentansprüche

1. Verfahren zum Bilden eines Dielektrikums (1; 7, 8) auf einem Halbleitersubstrat (2) mit folgenden Schritten:
a) Implantieren von Ionen (5) in eine Oberflächenschicht (4) des Halbleitersubstrates (2), wobei die Ionen (5) eine erste dielektrische Schicht (7) bilden; und
b) Ausführen eines thermischen Oxidationsprozesses zum Bilden einer zweiten dielektrischen Schicht (8) auf der ersten dielektrischen Schicht (7).

2. Verfahren nach Anspruch 1,
**dadurch gekennzeichnet,**
**dass** das Halbleitersubstrat (2) vorzugsweise als Siliziumsubstrat (2) ausgebildet ist.

3. Verfahren nach Anspruch 1 oder 2,
**dadurch gekennzeichnet,**
**dass** die implantierten Ionen (5) Stickstoffionen (5) sind.

4. Verfahren nach einem der vorangehenden Ansprüche,
**dadurch gekennzeichnet,**
**dass** ein Reinigungsprozess zur Reinigung der Halbleitersubstrat-Oberfläche (3) vor dem Bilden des Dielektrikums (1; 7, 8) ausgeführt wird.

5. Verfahren nach einem der vorangehenden Ansprüche,
**dadurch gekennzeichnet,**
**dass** die durch die Ionenimplantation entstandenen Fehlstellen mittels eines Temperungsverfahrens vor dem thermischen Oxidationsprozess beseitigt werden.

6. Verfahren nach Anspruch 1,
**dadurch gekennzeichnet,**
**dass** die implantierten Ionen die Oxidation im ungestörten Bereich hemmen, aber nicht im Bereich von Defekten, wodurch im Bereich der Defekte ein Oxid entsteht, das eine mindestens so große Durchbruchspannung aufweist wie im ungestörten Bereich.

7. Verfahren nach einem der vorangehenden Ansprüche,
**dadurch gekennzeichnet,**
**dass** eine Streuschicht (6) zum Herstellen einer vorbestimmten Eindringtiefe der Ionen (5) vor der Implantation erzeugt und nach der Implantation noch vor dem thermischen Oxidationsprozess wieder entfernt wird.
